# EUROPÄISCHE PATENTSCHRIFT

(11) **EP 0 693 223 B1**
(45) Veröffentlichungstag und Bekanntmachung des Hinweises auf die Patenterteilung: **24.02.1999**
(21) Anmeldenummer: 94911837.6
(22) Anmeldetag: 08.04.1994
(51) Int. Cl.: H01L 21/98, H01L 21/607

(54) **VERFAHREN ZUR VERBINDUNG ELEKTRISCHER KONTAKTSTELLEN**
METHOD OF JOINING ELECTRICAL CONTACT POINTS
PROCEDE POUR LA JONCTION DE POINTS DE CONTACTS ELECTRIQUES

(30) Priorität: 08.04.1993 DE 4311762
(43) Veröffentlichungstag der Anmeldung: 24.01.1996
(73) Patentinhaber: KEMMER, Josef, Dr., D-85764 Oberschleissheim (DE)
(72) Erfinder: KEMMER, Josef, Dr., D-85764 Oberschleissheim (DE)
(74) Vertreter: Münich, Wilhelm, Dr.
(86) Internationale Anmeldenummer: DE9400390
(87) Internationale Veröffentlichungsnummer: WO9424701

(56) Entgegenhaltungen:
- EP-A- 0 186 829
- EP-A- 0 238 066
- EP-A- 0 522 518
- EP-A- 0 536 076
- DE-A- 3 914 015
- US-A- 4 990 462
- JOURNAL OF APPLIED PHYSICS, Bd.58, Nr.3, August 1985, WOODBURY, US Seiten 1240 - 1247 T.R.ANTHONY 'dielectric isolation of silicon by anodic bonding'

## Beschreibung

### Technisches Gebiet

Die Erfindung betrifft ein Verfahren zur gleichzeitigen Verbindung von zwei oder mehreren Substraten mit einem oder mehreren elektrischen Kontakten unter Benutzung des anodischen Bondverfahrens gemäß dem Patentanspruch 1.

### Stand der Technik

Die gleichzeitige Herstellung vieler elektrischer Kontaktstellen ist eine Aufgabe, die insbesondere in der Mikroelektronik zu bewältigen ist. Dazu sind eine Reihe von Verfahren in Gebrauch, von denen die bekanntesten das Ultraschallbonden und das Bumpbonden sind. Das Ultraschallbonden ist zwar ein sehr ausgereiftes Verfahren, hat aber den Nachteil, daß aufgrund der Drahtdicke die Kontaktfläche etwa 50 µm x 100 µm groß sein muß. Ein weiterer Nachteil besteht darin, daß ein gewisser Anteil der Ultraschallverbindungen defekt sein kann. Im Laufe der Zeit kommt es zum Abriß der Bonddrähte. In der Regel werden die Bondungen automatisch ausgeführt. Es gibt jedoch auch spezielle Bauelemente, wie z.B. die sog. Streifendetektoren zum Nachweis ionisierender Strahlung, bei denen bis zu mehrere tausend Kontakte manuell gebondet werden müssen. Dies ist ein extrem aufwendiger Prozeß, bei dem es zu mangelhaften Verbindungen kommen kann.

Der Artikel in Journal of Applied Physics, Bd. 58, Nr. 3, 1985, Seiten 1240-1247, T.R. Anthony, beschreibt das anodische Bondverfahren.

### Darstellung der Erfindung

Das Bumpbonden ist ein technologisch anspruchsvoller Prozeß, bei dem die Kontaktstellen mit kugelförmigen, niedrigschmelzenden Metallen beschichtet werden. Beim Verbindungsvorgang werden beide Bauteile, der elektronische Chip und das Substrat, aufeinander gelegt und erwärmt. Dabei legieren die Kontaktkugeln mit den Metallkontakten auf dem Substrat. Diese Technologie ist nicht mit allen Bauelementen kompatibel und steht in vielen Fertigungen oder Labors nicht zur Verfügung.

Die beschriebenen Nachteile beider Verfahren können durch das erfindungsgemäße Verfahren der gleichzeitigen Verbindung mehrerer Kontaktstellen vermieden werden. Bei dieser Technik macht man von dem bekannten anodischen Bondverfahren Gebrauch, welches in der Sensortechnologie zur Verbindung von Siliciumchips mit Glassubstraten verwendet wird. Dabei wird die saubere plane Siliciumfläche mit einer sauberen planen Pyrexglasfläche zusammengebracht, auf Temperaturen bis ca. 400 °C erwärmt, ein elektrisches Feld angelegt und die beiden Teile lokal zusammengedrückt. Unter diesen Bedingungen kommt es zu einer innigen, unlösbaren Verbindung zwischen dem Pyrexglas und dem Siliciumchip.

Dieses Verfahren wurde bisher in der Verbindungstechnik benutzt, um z.B. Sensorchips aus Silicium mit einem Glassubstrat zu verbinden, jedoch nicht zum Herstellen elektrischer Kontakte. Das Verfahren kann erfindungsgemäß dazu benutzt werden, gleichzeitig eine große Anzahl elektrischer Leitungen miteinander zu verbinden. Dabei wird nach Anspruch 1 von der enormen Verbindungskraft zwischen Pyrexglas und Silicium Gebrauch gemacht, die die Kontakte nach Anspruch 2 gegeneinander, ineinander oder aufeinander preßt. Durch Ultraschalleinwirkung oder Legierung vor, während oder nach dem Bondprozeß kann nach Anspruch 3 bzw. Anspruch 4 die elektrische Verbindung noch verbessert werden.

Nach dem heutigen Wissensstand funktioniert das anodische Bonden besonders gut zwischen Silicium und Pyrexglas. Aus diesem Grunde müssen die beiden zu verbindenden Substrate im Bondbereich nach Anspruch 5 und 6 vorzugsweise eine Pyrexglasfläche bzw. eine Siliciumoberfläche oder eine Siliciumoxidoberfläche aufweisen. Im einfachsten Fall können z.B. Siliciumchips mit metallisierten Pyrexsubstraten direkt gebondet werden. Es ist jedoch manchmal vorteilhafter Substrate aus anderem Material zu verwenden, die dann lediglich im Bondbereich mit Pyrexglas bzw. Silicium beschichtet werden müssen.

Eine elektrische Verbindung läßt sich nach Anspruch 7 am einfachsten zwischen zwei Substraten herstellen, wenn diese jeweils eine dünne Metallschicht im Kontaktbereich aufweisen. Diese Metallschicht kann z.B., wie in der Halbleiterfertigung üblich, durch einen Sputterprozeß aufgebracht und photolithographisch strukturiert sein. Werden derartig präparierte Substrate mit ihren Kontaktflächen in Berührung gebracht, so werden sich in der Regel die Bondbereiche, da sie tiefer liegen, nur dann berühren können, wenn sich mindestens eines der beiden Substrate verformt. Dabei tritt ein Luftspalt zwischen der Kontaktstelle und dem Bondgebiet auf, dessen Breite von dem Abstand der beiden Substrate, deren Elastizität und unter Umständen dem Anpreßdruck beim Bondvorgang abhängig ist. Die doppelte Breite dieses Luftspaltes plus gewünschter Breite des Bondbereiches stellen gleichzeitig auch die Untergrenze für den Abstand der Kontaktstellen dar, falls zwischen ihnen gebondet werden soll.

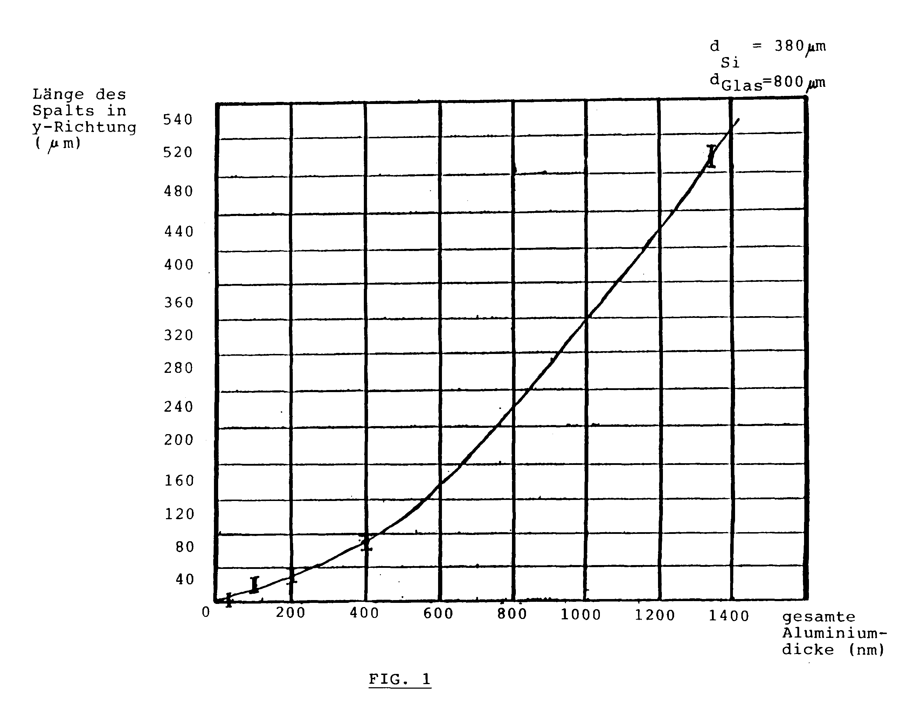

In Fig. 1 ist die Breite dieses Luftspaltes als Funktion des Abstandes (Summe der Schichtdicke beider Kontakte) aufgetragen. Hierbei wurde als erstes Substrat eine Siliciumscheibe von 380 µm Dicke und als zweites Substrat eine Pyrexglasscheibe von 800 µm Dicke verwendet. Es ist zu sehen, daß bei einer Gesamtkontaktdicke von 1,35 µm der Spalt etwa 500 µm breit wird. Die Kontaktstellen müssen demnach mehr als 1 mm voneinander entfernt sein, falls zwischen ihnen gebondet werden soll. Dies ist allerdings nicht unbedingt erforderlich. Um eine Spaltbreite von nur einigen µm zu erreichen, müssen die Abstände unter 10 nm reduziert werden. Dies läßt sich nach Anspruch 8 auch ohne Verringerung der Kontaktmetalldicke dadurch erreichen, daß der Kontaktbereich in mindestens eines der Substrate eingebettet wird.

Da die elektrischen Kontakte durch Gegeneinanderpressen der beiden Substrate im Kontaktbereich zustande kommen, ist es vorteilhaft, wenn nach Anspruch 9 diese leicht verformbar sind. Dies ist z.B. für Metalle wie Aluminium oder Gold zutreffend. Besonders vorteilhaft kann es sein, spezielle Kontaktstrukturen zu benutzen, die zahnförmig ineinandergreifen. Dies wird später an einem Ausführungsbeispiel gezeigt.

Für manche Anwendungen ist es nach Anspruch 10 ausreichend, die Metallkontakte auf einem der beiden Substrate als Federn oder Stifte auszuführen, die wie bei bekannten Steckverbindungen den Kontakt herstellen.

Sind sehr viele elektrische Kontakte zu verbinden, so können nach Anspruch 11 die dazugehörigen Leiterbahnen in mehreren übereinander liegenden Ebenen in die Substrate eingebettet werden. Dabei kann man die bekannten Techniken für die Herstellung mehrlagiger Substrate zur Anwendung bringen.

Besonders interessant ist das erfindungsgemäße Verfahren nach Anspruch 13 für das Kontaktieren vom Silicium-Bauelement mit sehr vielen Kontakten, da gleichzeitig mit der Herstellung der elektrischen Kontakte das Bauelement unlösbar mit dem zweiten Substrat verbunden wird. Wenn das zweite Substrat gleichzeitig als Chipträger mit den üblichen Steckkontakten ausgeführt ist, entfällt die Montage des Chips auf dem Träger.

Für eine Reihe von Anwendungen in der Grundlagenforschung ist es erforderlich mehrere großflächige Halbleitersensoren, sog. Streifendetektoren möglichst eng miteinander elektrisch und mechanisch, unter möglichst geringem Materialeinsatz, zu verbinden. Dies läßt sich mit diesem Verfahren nach Anspruch 12 leicht erreichen, da das zweite Substrat sowohl zur Kontaktierung der Streifendetektoren untereinander als auch als mechanisches Verbindungsteil dienen kann.

Auch für ein sandwichartiges Zusammenpacken mehrerer Lagen von Halbleiterbaulementen, insbesondere Strahlungsdetektoren oder Speicherchips, ist das Verfahren nach Anspruch 13 geeignet.

Nach Anspruch 14 kann z.B. ein metallisiertes zweites Substrat auch einen Kontakt zu dotierten Bereichen eines ersten Substrates, vorzugsweise eines Siliciumbauelementes, herstellen. Schließlich bietet das erfindungsgemäße Verfahren nach Anspruch 14 sogar die Möglichkeit MIS-, vorzugsweise MOS-Strukturen zu realisieren, die als wesentliche Teile von Bauelementen, insbesondere von Strahlungsdetektoren, benutzt werden können.

### Kurze Beschreibung der Zeichnungen

Das erfindungsgemäße Verfahren soll nun anhand einiger Ausführungsbeispiele erläutert werden, die in den folgenden Figuren dargestellt sind. Dabei zeigen:
- Fig. 1: die Breite des Luftspaltes zwischen den Leiterbahnen und den Bondbereichen in Abhängigkeit von dem Abstand der beiden Substrate. Als Substrate wurden ein Pyrexglas mit 800 µm Dicke und ein Siliciumscheibe mit 380 µm Dicke verwendet.
- Fig. 2: einen Querschnitt durch den Kontaktbereich zweier Substrate (S1,S2), wobei die Leiterbahnen (KG2, M2) des zweiten Substrates (S2) in dieses eingebettet sind.
- Fig. 3: trapezförmig strukturierte Kontakte (M1,M2), die beim Kontaktieren ineinandergreifen.
- Fig. 4: eine schematische Darstellung des Kontaktbereichs eines konventionellen Streifendetektors zur Ortsbestimmung durchfliegender Teilchen in der Aufsicht.
- Fig. 5: eine schematische Aufsicht auf den Kontaktbereich eines Streifendetektors, der mit Hilfe der erfindungsgemäßen Verbindung kontaktiert ist.
- Fig. 6: die Aufsicht von mehreren Streifendetektoren, die mit Hilfe von Kontaktsubstraten elektrisch und mechanisch miteinander verbunden sind.
- Fig. 7a: eine schematische Darstellung eines zweiten Substrates (KSL) aus Pyrexglas, das leiterförmig gestaltet ist und zur Aufnahme von Streifendetektoren und der Ausleseelektronik (AE) dient.
- Fig. 7b: die Aufsicht auf mehrere Streifendetektoren (SD1, SD2, SD3), die mit Hilfe eines leiterförmigen Kontaktsubstrates (KSL) elektrisch miteinander verbunden und mechanisch fixiert sind.

Die Bedeutung der Fig. 1 wurde bereits vorher erläutert. Aus der Graphik ist der Zusammenhang zwischen Substratabstand und Breite des Luftspaltes zwischen Leiterbahn und Bondstelle aufgetragen. Aus ihr können die Mindestabstände der Leiterbahnen für dieses System abgelesen werden.

Da die Leiterbahnen in der Mikroelektronik aus Leitfähigkeitsgründen typischerweise Dicken von ca. 1 µm bis 1,5 µm aufweisen, ist es sinnvoll die Bahnen in mindestens eines der Substrate (S1) oder (S2) einzubetten, um den Abstand der Bondbereiche möglichst unter 40 nm zu reduzieren. Eine derartige Anordnung ist im Ausführungsbeispiel der Fig. 2 dargestellt. Auf der linken Seite ist eine Gruppe (KG1, KG2) eng nebeneinanderliegender Kontakte zu sehen, die nur im Außenbereich (AB) anodisch gebondet werden. In der rechten Gruppe dagegen sind die Metallkontakte (M1, M2) jeweils durch eine Bondfläche (BF) voneinander getrennt. Dieses Beispiel soll zeigen, daß der Entwurf der Kontaktbereiche in hohem Maße an das spezielle Design eines Bauelementes angepaßt werden kann. Dies ist ein Vorteil, den keines der bekannten Kontaktierungsverfahren bieten kann.

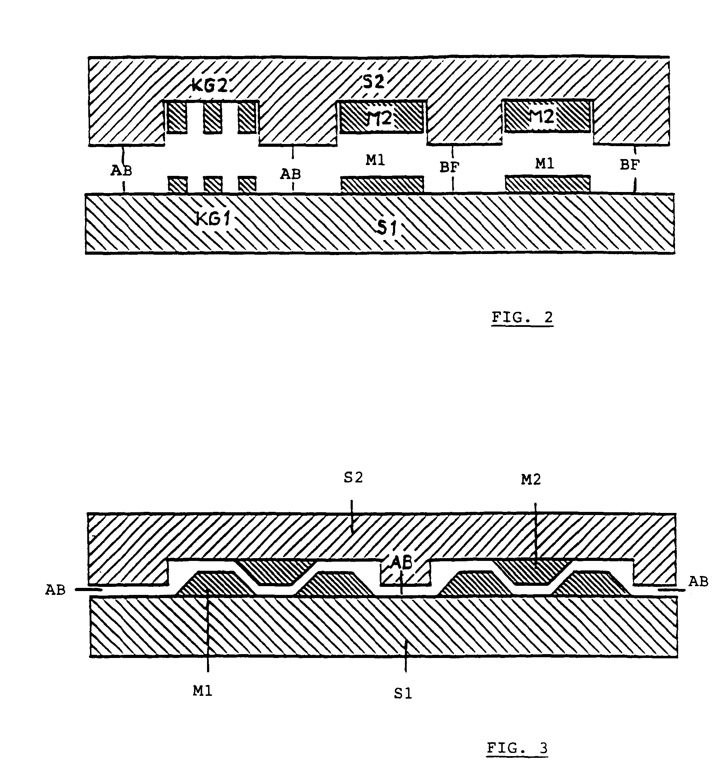

In Fig. 3 sind die Metallkontakte der beiden Substrate (S1) und (S2) trapezförmig gestaltet und greifen beim Ausführen des Bondvorganges in den Bereichen (AB) ineinander, so daß sich bei genauer Justage eine sehr innige Verbindung der Metallschichten (M1) und (M2) erreichen läßt.

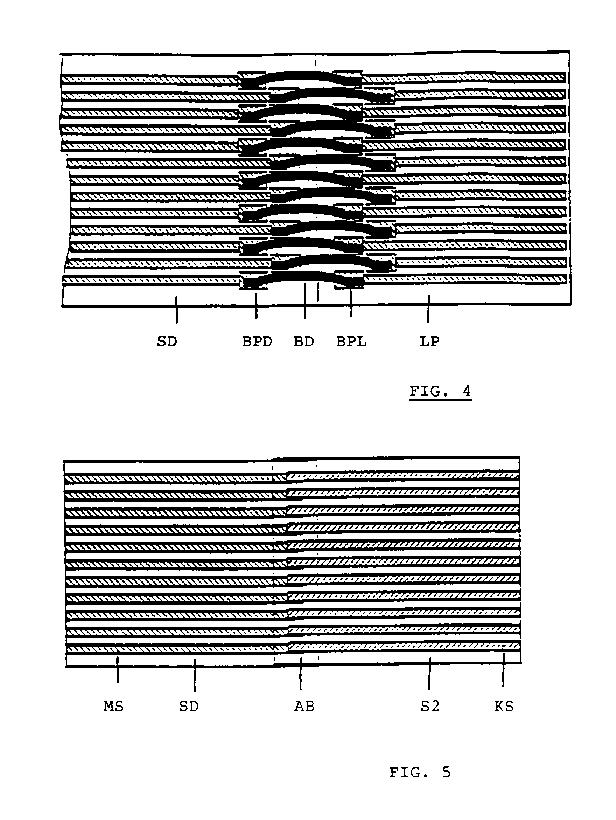

Da das erfindungsgemäße Kontaktierungsverfahren besonders vorteilhaft bei Bauelementen mit extrem hoher Kontaktdichte ist, sind in Fig. 4 und Fig. 5 die Kontaktbereiche eines Streifendetektors (SD) schematisch dargestellt. In Fig. 4 sind die Bondpads (BPD) des Detektors mit den Bondpads (BPL) der Leiterplatine (LP) durch Drähte (BD) verbunden, die durch konventionelles Ultraschallbonden angebracht wurden. In Fig. 5 sind die Metallstreifen (MS) des Streifendetektores (SD) direkt auf die Kontaktstreifen (KS) des Substrates (S2) gepreßt. Pressung und anodisches Bonden finden im Randbereich (AB) statt. Diese Detektoren können mehrere tausend Kontaktstellen aufweisen, so daß bei der klassischen Ultraschallverbindung die Bondpads in mehreren Reihen angeordne werden müssen und somit wertvolle Sensorfläche verloren geht. Beim erfindungsgemäßen Kontaktieren sind überhaupt keine zusätzlichen Kontaktpads erforderlich, da direkt auf die Streifendioden kontaktiert werden kann. Damit vereinfacht sich nicht nur das Layout des Detektors sondern auch die Kontrolle der elektrischen Parameter im Kontaktbereich (AB). Desweiteren ist das Problem des Verbiegens und die Kurzschlußgefahr der Bonddrähte (BD) völlig eliminiert.

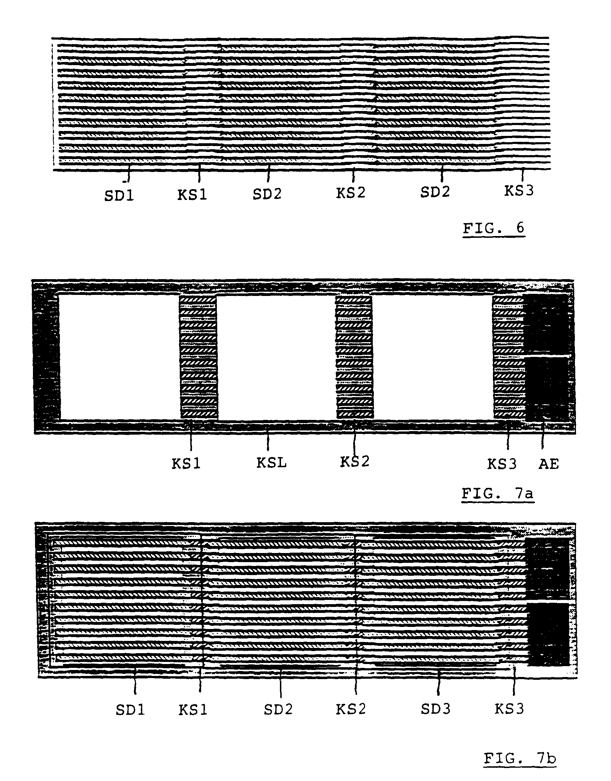

Die besonderen Vorteile des gleichzeitigen Kontaktierens werden beim Zusammensetzen von Arrays von Streifendetektoren ersichtlich, wie sie in den Experimenten der Hochenergiephysik erforderlich sind. Dies ist schematisch in Fig. 6 dargestellt, wo mehrere Streifendetektoren (SD1, SD2, SD3) mit Hilfe von metallisierten Kontaktsubstraten (KS1, KS2) völlig freitragend miteinander verbunden sind. Die Verbindung zur Ausleseelektronik wird durch ein metallisiertes Substrat (KS3) hergestellt. Eine stabilere Konfiguration ist in Fig. 7a bzw. Fig. 7b zu sehen, bei der das Kontaktsubstrat gleichzeitig neben der elektrischen Verbindung auch als mechanische Stütze benutzt wird. Es ist aus Stabilitätsgründen als ein leiterförmiger Rahmen (KSL) ausgeführt auf den die Detektoren (SD1, SD2, SD3) anodisch gebondet sind. Die Zwischenräume sind erforderlich um einen Teilchenstrahl passieren zu lassen. Die Bondverbindung kann am Randbereich der rechteckigen Detektoren stattfinden. Die elektrische Kontaktierung erfolgt in den Kontaktbereichen (KS1, KS2, KS3). Auf dem Substrat (KSL) können auch Teile der Ausleseelektronik (AE) integriert werden.

Auch zur Herstellung eines in P 41 14 821.5 bzw. P 41 20 443.3 beschriebenen Streifendetektors kann das beschriebene Verfahren herangezogen werden. Dieser Detektor benutzt als Streifen keine dotierten Bereiche, sondern Akkumulations- und Inversionsschichten, die mit Hilfe von MOS-Strukturen erzeugt werden. Solche MOS-Strukturen lassen sich durch Anbonden von metallisierten Substraten auf beiden Seiten einer oxidierten Siliciumscheibe ausbilden. Wenn die Dicke dieser Substrate z.B. nur 100 µm beträgt, so stellen sie für manche Strahlung kein großes Hindernis dar, dienen aber gleichzeitig als eine Schutzschicht für das darunter liegende Silicium.

Die hier aufgeführten Beispiele wurden ausgewählt, um die Einsatzmöglichkeit der erfindungsgemäßen gleichzeitigen Kontaktierung zu veranschaulichen. Sie decken jedoch keineswegs alle Anwendungsfälle ab. Insbesondere ist es möglich anstelle der Substratkombination Silicium/Pyrexglas auch andere anodisch bondbare Substrate, wie z.B. Silicium/Silicium zu verwenden. Dieses Paar weist den Vorteil auf, daß aufgrund des gleichen Materials keine mechanischen Spannungen auftreten und daß durch anisotrope Atztechniken Gräben für die Leiterbahnen hergestellt werde können. Dieses Ziel kann allerdings auch durch Ersatz des Pyrexglases, z.B. durch mit Pyrexglas beschichtetes Silicium, erreicht werden.

## Patentansprüche

1. Verfahren zur Verbindung mehrerer elektrischer Kontaktstellen mindestens eines Substrates mit entsprechenden Kontaktstellen weiterer Substrate,
**gekennzeichnet** durch folgende Schritte:
- als Substrate werden Substratkombinationen gewählt, die anodisch bondbar sind,
- die Substrate werden derart aufeinander gelegt, daß die jeweiligen Kontaktstellen der Substrate zumindest teilweise übereinander zu liegen kommen,
- die Substrate werden anschließend durch anodisches Bonden miteinander verbunden.

2. Verfahren nach Anspruch 1,
dadurch **gekennzeichnet**, daß die elektrischen Kontakte durch Andruck der Kontaktstellen zustande kommen.

3. Verfahren nach Anspruch 1,
dadurch **gekennzeichnet**, daß vor, während oder nach dem anodischen Bondvorgang eine Ultraschallbondung durchgeführt wird.

4. Verfahren nach Anspruch 1,
dadurch **gekennzeichnet**, daß vor, während oder nach dem anodischen Bondvorgang eine Legierung stattfindet.

5. Verfahren nach einem der Ansprüche 1 bis 4,
dadurch **gekennzeichnet**, daß mindestens eines der beiden Substrate im Bondbereich eine Pyrexglasfläche aufweist.

6. Verfahren nach einem der Ansprüche 1 bis 5,
dadurch **gekennzeichnet**, daß mindestens eines der beiden Substrate im Bondbereich eine Siliciumoberfläche oder eine Siliciumoxidoberfläche aufweist.

7. Verfahren nach einem der Ansprüche 1 bis 6,
dadurch **gekennzeichnet**, daß die Metallkontakte in Form dünner Schichten auf mindestens einem der Substrate aufgebracht sind.

8. Verfahren nach einem der Ansprüche 1 bis 7,
dadurch **gekennzeichnet**, daß die Kontaktstellen auf mindestens einem der beiden Substrate in den Substratkörper so tief eingebettet sind, daß sich beim Bondvorgang die Bondbereiche der beiden Substrate berühren können.

9. Verfahren nach einem der Ansprüche 1 bis 8,
dadurch **gekennzeichnet**, daß die Metallkontakte auf mindestens einem der beiden Substrate leicht verformbar sind.

10. Verfahren nach einem der Ansprüche 1 bis 9,
dadurch **gekennzeichnet**, daß die Metallkontakte auf mindestens einem der beiden Substrate elastisch oder steckbar sind.

11. Verfahren nach einem der Ansprüche 1 bis 10
dadurch **gekennzeichnet**, daß mindestens eines der beiden Substrate Leiterbahnen in mehreren Lagen enthält.

12. Verfahren nach einem der Ansprüche 1 bis 11,
dadurch **gekennzeichnet**, daß Teile wenigstens eines Substrates Siliciumbauelemente sind, und daß das zweite Substrat gleichzeitig als mechanisches Verbindungselement zwischen mindestens zwei Siliciumbauelemente dient.

13. Verfahren nach Anspruch 12,
dadurch **gekennzeichnet**, daß auf beiden Seiten mindestens eines Substrates Siliciumbauelemente montiert werden oder sind.

14. Verfahren nach Anspruch 13,
dadurch **gekennzeichnet**, daß die Kontaktstellen von mindestens einem Substrat nicht metallisiert, sondern durch Dotierung leitfähig gemacht sind, und/oder daß die Kontaktstellen mindestens des ersten Substrates ein Dielektrikum, vorzugsweise eine Oxidschicht, darstellt.

## Claims

1. Method of joining several electrical contact points of at least one substrate with corresponding points of contact of further substrates,
**characterised** by the following steps:
- as substrates combination of substrates are selected which are suitable for anodic bonding,
- the substrates are superimposed in such a manner that the respective contact points of the substrates are placed one on top of the other at least partly,
- the substrates are subsequently bonded to each other by anodic bonding.

2. Method according to Claim 1,
**characterised** in that said electrical contacts are achieved by pressing said contact points.

3. Method according to Claim 1,
**characterised** in that ultrasonic-bonding is performed prior to, during or after said anodic bonding process.

4. Method according to Claim 1,
**characterised** in that an alloying process is performed prior to, during or after said anodic bonding process.

5. Method according to any of the Claims 1 to 4,
**characterised** in that at least one of the two substrates presents a Pyrex glass surface in the bonding region.

6. Method according to any of the Claims 1 to 5,
**characterised** in that at least one of the two substrates presents a silicon surface or a silicon oxide surface in the bonding region.

7. Method according to any of the Claims 1 to 6,
**characterised** in that said metal contacts are applied in the form of thin films on at least one of said substrates.

8. Method according to any of the Claims 1 to 7,
**characterised** in that said contact points on at least one of the two substrates are embedded into the substrate body at a level so deep that the bonding regions of the two substrates cannot contact each other during the bonding process.

9. Method according to any of the Claims 1 to 8,
**characterised** in that said metal contacts on at least one of the two substrates are easily deformable.

10. Method according to any of the Claims 1 to 9,
**characterised** in that said metal contacts on at least one of the two substrates are elastic or adapted for plugging.

11. Method according to any of the Claims 1 to 10,
**characterised** in that at least one of the two substrates contains conducting paths in several layers.

12. Method according to any of the Claims 1 to 11,
**characterised** in that parts of at least one substrate are silicon devices and that the second substrate has at the same time the function of a mechanical connector element between at least two silicon devices.

13. Method according to Claim 12,
**characterised** in that silicon devices are mounted on both sides of at least one substrate.

14. Method according to Claim 13,
**characterised** in that said contact points of at least one substrate are not metallized but rather rendered conductive by doping, and/or that said contact points of at least the first substrate are a dielectric, preferably an oxide layer.

## Revendications

1. Procédé à joindre plusieurs spots de contact électriques d'au moins un substrat aux spots de contact correspondants d'autres substrats,
**caractérisé** par les opérations suivantes:
- des combinaisons de substrats sont choisis comme substrats qui sont appropriés au bondage anodique,
- les substrats sont empilés de façon que les spots de contact respectifs des substrats se trouvent l'un sur l'autre au moins en partie,
- les substrats sont ensuite joints l'un l'autre par bondage anodique.

2. Procédé selon la revendication 1,
**caractérisé** en ce que lesdits contacts électriques sont achevés en pressant lesdits spots de contact.

3. Procédé selon la revendication 1,
**caractérisé** en ce qu'une opération de bondage à ultrasons est réalisé avant, en cours de ou après ladite opération de bondage anodique.

4. Procédé selon la revendication 1,
**caractérisé** en ce qu'une opération d'alliage est réalisée avant, en cours de ou après ladite opération de bondage anodique.

5. Procédé selon une quelconque des revendications 1 à 4,
**caractérisé** en ce qu'au moins un des deux substrats a une surface en Pyrex dans la zone de bondage.

6. Procédé selon une quelconque des revendications 1 à 5,
**caractérisé** en ce qu'au moins un des deux substrats a une surface au silicium ou à oxyde de silicium dans la zone de bondage.

7. Procédé selon une quelconque des revendications 1 à 6,
**caractérisé** en ce que lesdits contact métalliques sont appliqués sous forme de couches minces sur au moins un desdits substrats.

8. Procédé selon une quelconque des revendications 1 à 7,
**caractérisé** en ce que lesdits spots de contact sur au moins un des deux substrats sont noyés dans le corps du substrats à un niveau si bas que les zones de bondage des deux substrats ne peuvent pas contacter l'un l'autre au cours du processus de bondage.

9. Procédé selon une quelconque des revendications 1 à 8,
**caractérisé** en ce que lesdits contacts métalliques sur au moins un des deux substrats sont facilement déformables.

10. Procédé selon une quelconque des revendications 1 à 9,
**caractérisé** en ce que lesdits contacts métalliques sur au moins un des deux substrats sont élastiques ou enfichables.

11. Procédé selon une quelconque des revendications 1 à 10,
**caractérisé** en ce qu'au moins un des deux substrats contient des pistes conductrices en plusieurs couches.

12. Procédé selon une quelconque des revendications 1 à 11,
**caractérisé** en ce que des parties d'au moins un substrat sont des composants au silicium, et en ce que le deuxième substrat fait au même temps fonction d'un élément de connexion mécanique entre au moins deux composants au silicium.

13. Procédé selon la revendication 12,
**caractérisé** en ce que des composants au silicium sont montés sur les deux côtés d'au moins un substrat.

14. Procédé selon la revendication 13,
**caractérisé** en ce que lesdits spots de contact d'au moins un substrat ne sont pas métallisés mais rendus conducteurs par dopage, et/ou en ce que lesdits spots de contact du premier substrat au moins sont un diélectrique, de préférence une couche d'oxyde.
